# FASCICULE DE BREVET EUROPEEN

(11) **EP 1 564 857 B1**
(45) Date de publication et mention de la délivrance du brevet: **11.06.2008**
(21) Numéro de dépôt: 05100691.4
(22) Date de dépôt: 01.02.2005
(51) Int. Cl.: H02B 1/46, H05K 5/00, H02G 3/14, H02G 3/08

(54) **Boîte métallique notamment pour organes électriques**
Metallgehäuse, insbesondere für elektrische Geräte
Metal box particularly for electrical units

(30) Priorité: 10.02.2004 FR 0401317; 10.02.2004 FR 0401315
(43) Date de publication de la demande: 17.08.2005
(73) Titulaire: SCHNEIDER ELECTRIC INDUSTRIES SAS, 92500 Rueil-Malmaison (FR)
(72) Inventeur: BOUET, Emmanuel, 67200, SARRE UNION (FR); BUCHY, Bernard, 67320, SCHOENBOURG (FR); MEYER, Michel, 57412, ACHEN (FR)

(56) Documents cités:
- DE-A- 4 033 109
- DE-A1- 4 037 063
- DE-U- 29 811 893
- GB-A- 2 187 228
- US-A- 5 361 925

## Description

La présente invention concerne une boîte métallique destinée à loger des organes électriques, cette boîte comprenant un corps sensiblement parallélépipédique à fermer par un couvercle au moyen de vis ou pièces de charnières placées aux coins.

Par la suite et pour simplifier, le terme "couvercle" désignera aussi bien une porte qu'un couvercle proprement dit.

Certaines boîtes connues destinées à loger des organes électriques (voir par exemple GB 2187 228 et DE 40 33 109) ont un couvercle qui est doté aux coins de pièces de charnière ou de pièces à visser ou à fixer par rotation quart de tour. Ces pièces sont engagées dans des orifices prévus aux coins respectifs du couvercle. Le fabricant de la boîte doit fournir un grand nombre de couvercles en fonction des divers types ou calibres de vis souhaités par l'utilisateur.

Il est prévu d'après le document DE 298 11 893 de placer aux angles du couvercle d'une telle boîte des coins rapportés, fendus vers l'intérieur pour laisser passer le fût de la vis et s'engager par une forme en queue d'aronde sur une glissière propre au couvercle. Ce dispositif est de réalisation compliquée, nécessite une insertion latérale préalable de la vis dans le coin et n'est pas directement adaptable à un couvercle métallique.

L'invention a pour but de simplifier la réalisation d'un couvercle métallique à rapporter de façon étanche au corps d'une boîte pour organes électriques, et qui autorise de façon simple et peu coûteuse une différenciation visuelle du couvercle et une adaptation aisée à différents types de vis de fixation.

Selon l'invention, - le couvercle comprend une plaque mince à bords rabattus, la plaque étant dotée aux angles d'ouvertures traversantes découpées plus grandes que les logements des têtes des vis de fixation,
- le couvercle comprend des pièces de coin rapportées au-dessus de la plaque pour couvrir les ouvertures traversantes, en étant appliquées par un bandeau sur la face supérieure de la plaque,
- chaque pièce de coin comprend un logement adapté à une introduction de la vis de fixation respective selon son axe.
   L'ouverture traversante de la plaque mince peut être délimitée par des zones d'angle des bords rabattus qui se rejoignent.
   La pièce de coin peut présenter avantageusement une paroi latérale, soit en forme de dièdre, soit de forme incurvée, recouvrant les zones d'angle des bords rabattus du couvercle. La paroi latérale peut offrir vers l'intérieur des formes d'assemblage coopérant avec des formes complémentaires prévues sur les zones d'angle des bords rabattus et/ou offrir une chape d'assemblage par pincement sur le couvercle.
   La pièce de coin présente un logement adapté au type de vis de fixation, de préférence ménagé dans un plot tel que les zones d'angle des bords rabattus du couvercle sont insérées ou encastrées entre le plot et la paroi latérale.
   Un autre but de l'invention est de permettre de fixer de manière étanche le couvercle au corps d'une boîte pour organes électriques, sans altérer en pratique l'espace interne parallélépipédique du corps qui sert à loger les organes électriques, et ce à l'aide de moyens simples et peu coûteux.
   Cet autre but est atteint par le fait que,
- les extrémités des bords dressés situées aux coins du corps sont raccordées entre elles par des bords de transition, orientés de manière à ménager aux coins du corps des plages d'angle sensiblement triangulaires,
- sur le côté de la plage d'angle situé vers le couvercle est prévu un élément récepteur, disposé de façon étanche vis à vis de l'espace interne du corps, et coopérant, de façon également étanche vis à vis de l'espace interne et pratiquement sans réduire le volume utile de cet espace sous la plage d'angle, avec une vis de fixation du couvercle.

L'élément récepteur qui coopère avec la vis et en loge une partie ne fait pas saillie à l'intérieur du corps ou forme une saillie négligeable sous la plage d'angle triangulaire. Le volume situé à l'intérieur du corps sous la plage d'angle est dès lors complètement ou pratiquement complètement utilisable pour loger des éléments dans la boîte. La vis de fixation du couvercle peut être filetée ou du type quart de tour et l'élément récepteur est adapté à bloquer cette vis en position de fermeture.

Dans un premier mode de réalisation, on prévoit en au moins un coin du corps que le bord de transition oblique et la plage d'angle associée viennent d'emboutissage avec le reste du corps.

Dans un deuxième mode de réalisation, le bord de transition oblique et la plage d'angle associée viennent de pliage à partir d'une paroi latérale du corps et sont soudés à la paroi adjacente et au retour et au bord dressé de la paroi adjacente du corps.

Dans un troisième mode de réalisation, le bord de transition oblique et la plage d'angle associée sont prévus sur une pièce cornière, de forme générale triangulaire, rapportée et fixée de manière étanche aux retours et bords dressés des parois formant le coin respectif.

La plage d'angle peut présenter un passage traversant qui communique avec l'intérieur du corps, et l'élément récepteur est alors un insert borgne présentant une collerette fixée à la plage d'angle et un tube borgne pénétrant dans l'espace interne du corps sur une faible hauteur au-dessous de la plage, l'insert étant doté de formes internes pour le serrage de la vis de fixation par filetage ou quart de tour.

En variante, la plage d'angle peut être dépourvue de passage traversant. L'élément récepteur peut alors être un trou borgne embouti dans la plage d'angle et doté d'un filetage interne de serrage pour la vis de fixation. Il peut aussi être constitué par une pièce à fonction d'écrou, cette pièce d'écrou ayant une forme plate notamment en U renversé, dotée d'une âme à trou taraudé prévue pour coopérer avec la vis de fixation et de pattes de fixation à la face externe de la plage d'angle.

La description détaillée qui suit, en regard des dessins annexés, illustre un mode de réalisation donné à titre d'exemple.
La figure 1 représente en perspective une boîte métallique conforme à l'invention.
La figure 2 est une vue en perspective éclatée de la boîte et de son couvercle.
La figure 3 montre en perspective à plus grande échelle un coin du couvercle.
La figure 4 montre le coin illustré figure 3, vu de dessous.
La figure 5 est une vue éclatée du coin illustré figure 3.
La figure 6 est une coupe selon le plan VI-VI de la figure 3.
La figure 7 montre en perspective à plus grande échelle un coin du corps de boîte dans une première forme d'exécution.
La figure 8 montre le coin illustré figure 7, vu de l'intérieur du corps.
Les figures 9 et 10 sont des vues analogues à celle de la figure 7, montrant deux autres formes d'exécution du coin.
Les figures 11 à 13 illustrent, par des coupes selon les plans de biais P1 et P2 visibles figure 1, trois variantes d'exécution de l'assemblage du couvercle avec le corps.

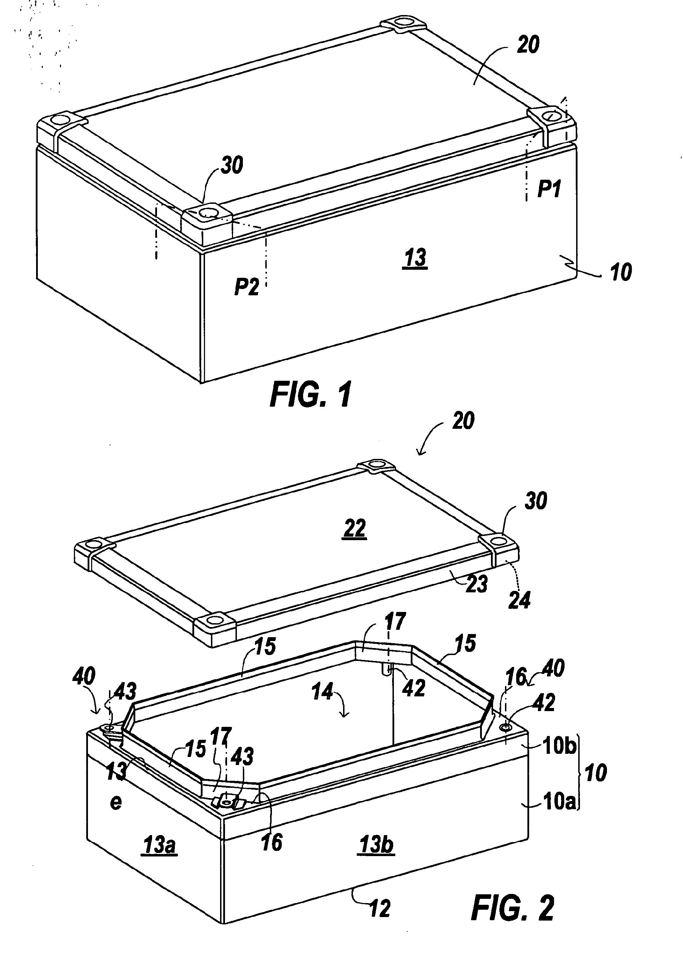

La boîte illustrée sur les figures 1 et 2 est une boîte métallique destinée à contenir des organes électriques de commande, de contrôle ou de connexion. Elle se compose d'un corps 10 de forme générale sensiblement parallélépipédique, ou quadrangulaire, et d'un couvercle 20 destiné à être posé et fixé de manière étanche sur le corps 10.

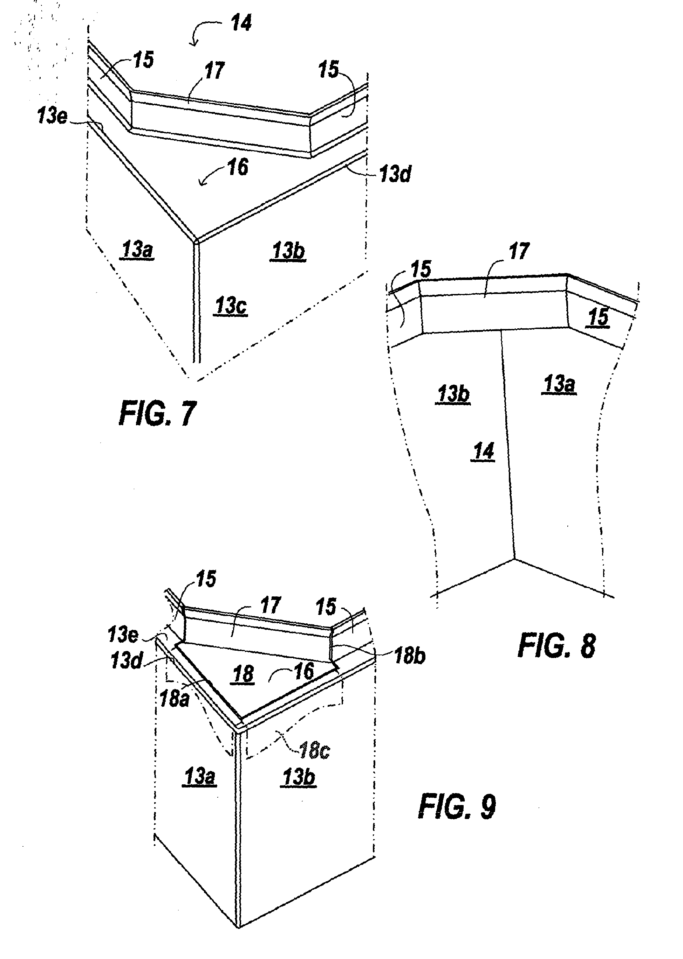

Le corps 10 présente un fond horizontal et quatre parois latérales 13. Les parois latérales 13, dont on peut voir par exemple les parois 13a,13b sur les figures 1 et 2, se raccordent entre elles à angle droit selon des arêtes verticales 13c (figure 7). Le fond 12 est muni d'éléments non représentés servant à fixer la boîte à un support et le corps de la boîte définit à l'opposé du fond une ouverture 14 sur le bord de laquelle doit s'appliquer le couvercle 20. Chaque paroi latérale 13 est pliée selon une arête horizontale 13d pour former un retour horizontal de faible largeur 13e (figure 7). Au retour 13e se raccorde un bord rectiligne 15 dressé verticalement. Les termes "horizontal" et "vertical" sont utilisés ici pour simplifier et se comprennent par référence aux figures.

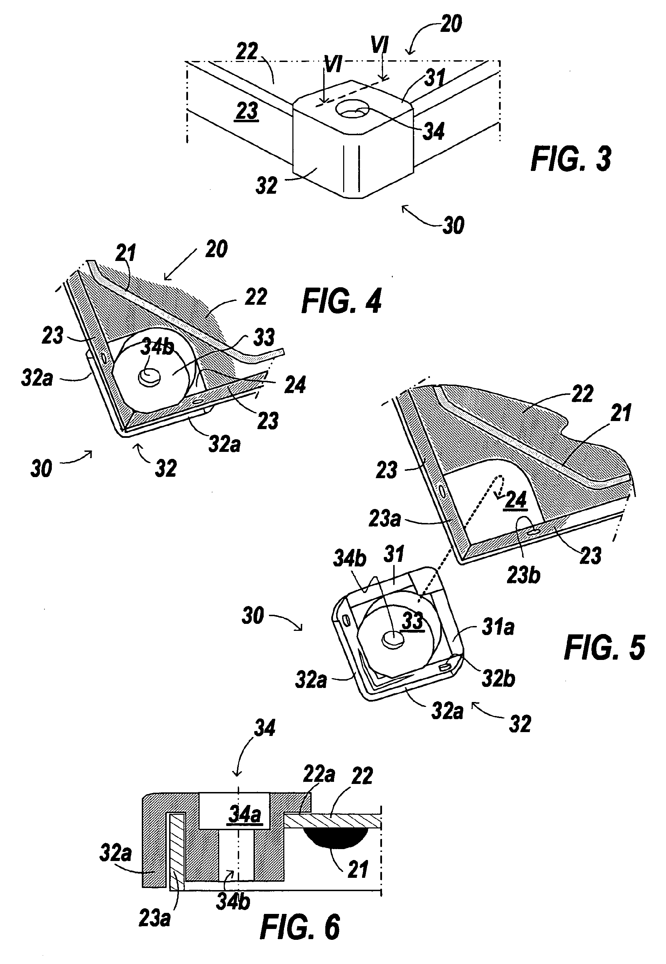

A chaque coin, le corps 10 présente une plage d'angle horizontale 16 attenante à un bord 17 dressé sensiblement verticalement. La plage 16 est sensiblement triangulaire et relie entre eux les retours 13e des parois adjacentes, tandis que le bord 17 relie entre eux les bords dressés 15 des parois 13a,13b, en formant ainsi entre ces bords une transition oblique, par exemple à 45°. La succession des bords 15 et 17 constitue un contour octogonal qui définit l'ouverture 14 et dont la tranche supérieure forme un appui pour un joint d'étanchéité (26, figure 6) du couvercle 20.

En référence à la figure 2, le couvercle 20 se compose pour sa part d'une plaque rectangulaire métallique mince 22 et de quatre pièces de coin rapportées 30, ces pièces étant en tout matériau approprié.

La plaque 22 est prolongée sur son pourtour par des bords rabattus 23 et, aux quatre angles, elle présente des ouvertures traversantes 24 (figure 5) découpées afin de recevoir les pièces de coin 30. Dans la région d'angle, les bords 23 ont, du côté interne et au niveau de l'ouverture 24, des zones d'angle 23a (figures 5 et 6) assurant le maintien de la pièce de coin 30 ; les zones 23a peuvent à cet effet être pourvues de formes d'assemblage 23b par exemple en creux.

La pièce de coin 30 sert à recouvrir la zone d'angle des bords 23. La pièce 30 présente une paroi supérieure 31 qui forme une équerre 31a d'appui (figure 5) sur une aire correspondante 22a de la face supérieure de la plaque 22. La pièce de coin 30 présente aussi une paroi latérale 32, de forme adaptée à celle des bords 23. Ici la paroi 32 se présente en tant que dièdre à deux faces 32a orthogonales entre elles et à la paroi supérieure 31. En variante, quand les bords rabattus 23 ont une forme incurvée, la pièce de coin 30 présente une paroi 32 à forme gauche adaptée à cette forme incurvée. Les faces 32a du dièdre sont dotées de formes 32b d'assemblage complémentaires des formes 23b. La pièce de coin 30 présente aussi un plot cylindrique 33 (figures 4 et 5) assurant l'emboîtement dans l'ouverture 24 et comportant un logement 34 pour une vis 41 de fixation du couvercle 20 sur le corps 10 de la boîte.

La fixation de la pièce de coin 30 peut en variante s'effectuer par pincement sur le couvercle 20, au moyen d'une chape appropriée. La chape de pincement peut être combinée aux formes d'assemblage 32b.

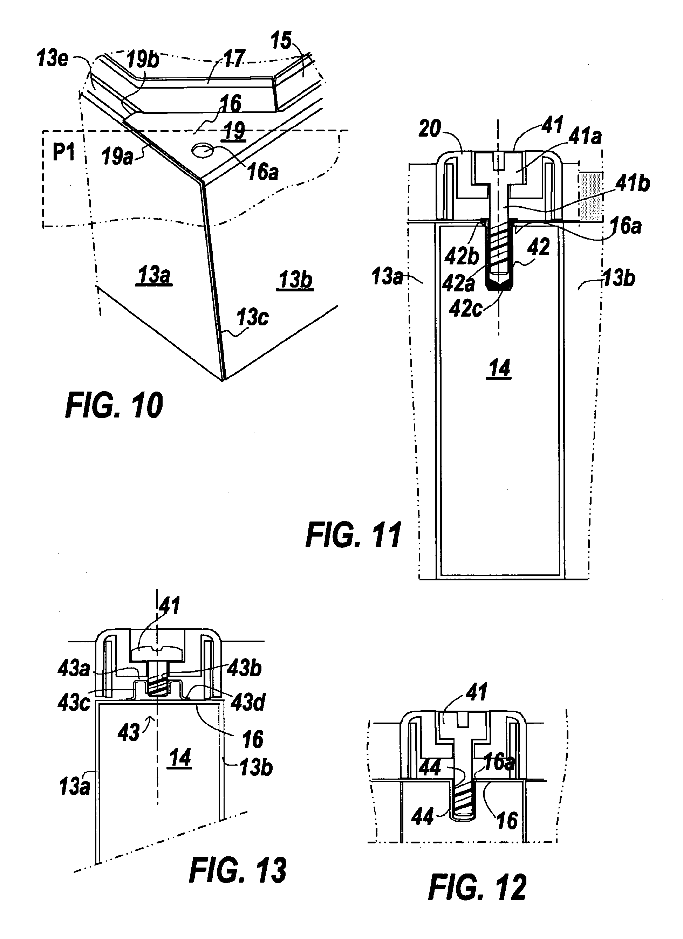

En référence à la figure 6, la vis 41 de fixation (figure 10) présente une tête 41 a logée dans une partie 34a du logement 34 et une tige 41 b filetée ou à forme d'accrochage, guidée dans le passage 34b. La vis 41 a un axe perpendiculaire au plan de la plaque 22 et elle est introduite selon cet axe dans la pièce de coin 30. La pièce de coin 30 est fixée sur l'aire d'appui 22a de la plaque 22 et contre les bords 23 par clipsage, collage, bouterollage ou autre mode de fixation analogue.

Les pièces de coin rapportées peuvent aisément être différenciées pour faire varier l'aspect du couvercle, tout en permettant d'adjoindre à une même plaque métallique 22 des éléments de serrage - vis ou éléments quart de tour - à empreintes variées, les plots 33 ayant une forme et un logement 34 adaptés à ces divers éléments de serrage.

Sur le corps 10 de la boîte, la réalisation de la plage d'angle et du bord de transition correspondant peut s'effectuer de différentes manières.

Dans un premier mode de réalisation (figure 7), la plage 16 et le bord de transition 17 ne marquent aucune discontinuité avec les retours 13e et les bords 15, car la partie du corps située vers le couvercle est obtenue d'une pièce par emboutissage. En réalité, pour faciliter la fabrication, on prévoit de réaliser le corps 10 en deux parties, l'une 10a présentant le fond 12 et une partie des parois 13, et l'autre 10b présentant l'autre partie des parois 13, notamment leurs retours 13e et bords dressés 15, et des dispositifs 40 de fixation du couvercle. La partie 10a est assemblée à la partie 10b (voir ligne de joint figure 2) par tout moyen approprié.

Dans un deuxième mode de réalisation (figure 9), une pièce cornière spécifique 18, par exemple emboutie, comportant la plage triangulaire 16 et le bord dressé 17, est rapportée dans un coin découpé correspondant du corps 10. La pièce cornière 18 est par exemple soudée d'une part aux retours 13e, notamment le long de lignes horizontales 18a parallèles aux parois 13 (et aux arêtes horizontales 13d), et d'autre part aux bords 15 le long de lignes verticales 18b. En variante, la pièce cornière 18 peut aussi présenter des ailes insérées sous les retours 13e, ces ailes pouvant le cas échéant être en appui sur les faces internes des parois 13a,13b.

Dans un troisième mode de réalisation (figure 10), l'une des parois, par exemple la paroi 13b, déterminant un coin, offre un rabat 19 qui vient de découpe et prolonge son retour 13e pour constituer la plage d'angle 16. Le rabat 19 peut être plié pour produire le bord oblique 17, ou sinon celui-ci peut être prévu en tant que prolongement du bord dressé 15 de la paroi adjacente 13a. L'application du rabat 19 est rendue étanche par exemple par soudage de son côté 19a à l'extrémité de l'arête horizontale 13d, et de son bord avant 19b (perpendiculaire au côté 19a) au retour 13e de la paroi 13a. Le bord 17, en tant que prolongement plié du bord 15 de la paroi 13a, est soudé d'une part au bord 15 de la paroi 13b et d'autre part à la surface horizontale de la plage 16.

La fixation étanche du couvercle 20 au corps 10 s'effectue au moyen de dispositifs 40 de fixation à vis associés aux plages d'angle 16 et n'altérant pas l'espace interne de la boîte. Il va de soi que les vis 41 associées au couvercle 20 peuvent être selon les cas des éléments de fixation quart de tour ou des vis filetées. Les axes de rotation des vis sont indiqués en traits mixtes sur les figures. La disposition adoptée selon l'invention permet de changer aisément les vis 41, en fonction du profil d'empreinte souhaité pour leur tête : cruciforme, double barre, carré, triangle, etc...
Dans un premier mode de réalisation (figure 11), un orifice de passage 16a est prévu dans la plage d'angle 16 et un insert borgne 42 est introduit dans cet orifice. L'insert borgne 42 présente une douille borgne 42c présentant un trou 42a par exemple taraudé avec lequel coopère la vis, et une collerette 42b permettant la fixation étanche, par exemple par soudage, à la plage d'angle 16.
Dans un deuxième mode de réalisation (figure 12), une opération d'emboutissage exécutée sur les plages 16 crée une forme borgne 44 similaire à un insert 42, cette forme étant de faible profondeur et taraudée en 44a pour recevoir la vis 41.
Dans un troisième mode de réalisation (figure 13), aucun orifice de passage n'est prévu dans la plage d'angle 16. Une pièce de serrage 43, notamment à fonction d'écrou, est placée sur la plage 16, cette pièce ayant une forme générale plate par exemple en U renversé. Plus précisément, la pièce 43 présente une âme horizontale 43a dotée d'un trou taraudé 43b, des ailes 43c et des pattes 43d de fixation à la face supérieure de la plage d'angle 16. La hauteur des ailes 43c est telle que la vis 41 associée au couvercle 20 puisse effectuer sa course de serrage.

### liste des références

| | | |
|---|---|---|
| **10** | **corps** | 10a, 10b parties |
| 12 | fond | |
| 13 | parois latérales | 13a, 13b parois contiguës |
| 14 | ouverture | |
| 15 | bord dressé | |
| 16 | plage d'angle | 16a passage |
| 17 | bord de transition oblique | |
| 18 | pièce cornière | 18a, 18b lignes |
| **20** | **couvercle** | |
| 22 | plaque plane | 22a aire d'appui du coin rapporté |
| 23 | bord rabattu | 23a zones d'angle 23b formes d'assemblage |
| 24 | évidement d'angle | |
| 26 | joint d'étanchéité | |
| **30** | **coin rapporté** | |
| 31 | plaquette supérieure | 31a équerre d'appui |
| 32 | paroi latérale | 32a faces perpendiculaires 32b formes d'assemblage |
| 33 | plot d'emboîtement | |
| 34 | logement de vis | 34a logement de la tête 34b passage de la tige |
| **40** | **Dispositifs de fixation** | |
| 41 | vis de fixation | 41 a tête de vis 41b tige filetée |
| 42 | insert borgne | 42a trou taraudé 42b collerette de fixation 42c tube |
| 43 | pièce d'écrou | 43a âme 43b trou taraudé 43c ailes 43d pattes de fixation |
| 44 | embouti borgne | 44a filetage |

## Revendications

1. Boîte métallique, notamment pour organes électriques, comprenant un corps (10) sensiblement parallélépipédique à fermer par un couvercle, porte ou organe analogue métallique (20) au moyen de vis (41) de fixation, placés aux coins, le corps (10) présentant quatre parois (13) latérales planes et une ouverture frontale, des logements (34) étant prévus pour les vis (41) de fixation aux angles du couvercle (20),
***caractérisée par le fait que***
- le couvercle (20) comprend une plaque mince (22) à bords rabattus (23), la plaque étant dotée aux angles d'ouvertures traversantes découpées (24) plus grandes que les logements des têtes des vis de fixation,
- le couvercle (20) comprend des pièces de coin (30) rapportées au-dessus de la plaque (22) pour couvrir les ouvertures traversantes, en étant appliquées par un bandeau (31) sur la face supérieure (22a) de la plaque,
- chaque pièce de coin (30) comprend un logement (34) adapté à une introduction de la vis de fixation respective (41) selon son axe.

2. Boîte selon la revendication 1, **caractérisée par le fait que** l'ouverture traversante (24) de la plaque mince (22) est délimitée par des zones d'angle (23a) des bords rabattus (23).

3. Boîte selon la revendication 1, **caractérisée par le fait que** la pièce de coin (30) présente une paroi latérale (32) recouvrant les zones d'angle (23a) des bords rabattus (23) du couvercle (20).

4. Boîte selon la revendication 3, **caractérisée par le fait que** la paroi latérale (32) offre vers l'intérieur des formes d'assemblage (32b) coopérant avec des formes complémentaires (23b) prévues sur les zones d'angle (23a) des bords rabattus (23).

5. Boîte selon la revendication 3, **caractérisée par le fait que** la paroi latérale (32) forme un dièdre (31).

6. Boîte selon la revendication 1, **caractérisée par le fait que** la pièce de coin (30) présente un logement (34) adapté au type de vis de fixation (41).

7. Boîte selon la revendication 6, **caractérisée par le fait que** la pièce de coin (30) présente une paroi latérale (32) recouvrant les zones d'angle (23a) des bords rabattus (23) du couvercle (20) et que le logement (34) adapté au type de vis de fixation est ménagé dans un plot (33) tel que les zones d'angle (23a) des bords rabattus (23) du couvercle sont insérées ou encastrées entre le plot (33) et la paroi latérale (32).

8. Boîte selon l'une des revendications 1 à 7, **caractérisée par le fait que**,
- l'ouverture frontale de son corps (10) est délimitée par un cadre continu formé par des retours (13e) de ses parois (13) latérales, chaque retour se prolongeant par un bord rectiligne (15) dressé de manière sensiblement parallèle à la paroi,
- les extrémités des bords dressés (15) situées aux coins du corps (10) sont raccordées entre elles par des bords de transition (17), orientés de manière à ménager aux coins du corps des plages d'angle (16) sensiblement triangulaires,
- sur le côté de la plage d'angle (16) situé vers le couvercle est prévu un élément récepteur (42,43,44), disposé de façon étanche vis à vis de l'espace interne du corps, et coopérant, de façon également étanche vis-à-vis de l'espace interne et pratiquement sans réduire le volume utile de cet espace sous la plage d'angle, avec la vis (41) de fixation du couvercle.

9. Boîte selon la revendication 8, **caractérisée par le fait que**, en au moins un coin du corps, le bord de transition oblique (17) et la plage d'angle (16) associée viennent d'emboutissage avec le reste du corps.

10. Boîte selon la revendication 8, **caractérisée par le fait que,** en au moins un coin du corps, le bord de transition oblique (17) et la plage d'angle (16) associée viennent de pliage à partir d'une paroi latérale (13b) du corps et sont soudés à la paroi adjacente (13a) et au retour et au bord dressé (15) de la paroi adjacente (13a).

11. Boîte selon la revendication 8, **caractérisée par le fait que**, en au moins un coin du corps, le bord de transition oblique (17) et la plage d'angle associée (16) sont prévus sur une pièce cornière (18) de forme générale triangulaire, rapportée et fixée de manière étanche aux retours (13e) et bords dressés (15) des parois (13a,13b) formant le coin respectif.

12. Boîte selon la revendication 11, **caractérisée par le fait que** la pièce cornière (18) a des ailes insérées sous les retours (13e) des parois latérales (13).

13. Boîte selon la revendication 8, **caractérisée par le fait que** la plage d'angle (16) présente un passage traversant (16a) qui communique avec l'intérieur du corps, et l'élément récepteur de vis est un insert borgne (42) présentant une collerette (42b) fixée à la plage d'angle et un tube borgne (42c) pénétrant dans l'espace interne du corps sur une faible hauteur au-dessous de la plage, l'insert étant doté de formes internes (42a) pour le serrage de la vis de fixation (41) par filetage ou effet quart de tour.

14. Boîte selon la revendication 8, **caractérisée par le fait que** la plage d'angle (16) est dépourvue de passage traversant, l'élément récepteur étant un trou borgne (44) embouti dans la plage d'angle (16) et doté d'un filetage interne (44a) de serrage pour la vis de fixation (41).

15. Boîte selon la revendication 8, **caractérisée par le fait que** la plage d'angle (16) est dépourvue de passage traversant, et l'élément récepteur est une pièce (43) à fonction d'écrou, cette pièce d'écrou ayant une forme plate notamment en U renversé, dotée d'une âme (43a) à trou taraudé prévue pour coopérer avec la vis de fixation (41) et de pattes (43d) de fixation à la face externe de la plage d'angle (16).

16. Boîte selon la revendication 8, **caractérisée par le fait que** la vis (41) de fixation du couvercle est du type quart de tour et l'élément récepteur (42,43) est adapté à bloquer cette vis en position de fermeture.

17. Boîte selon la revendication 8, **caractérisée par le fait que** chaque retour se prolongeant par un bord rectiligne (15) dressé de manière sensiblement parallèle à la paroi constitue un contour continu d'application d'un joint (26) assurant l'étanchéité du couvercle (20).

## Claims

1. Metal box, in particular for electrical units, comprising a substantially parallelepipedal body (10) to be closed by a lid, door or similar metal unit (20) using fixing screws (41), positioned at the corners, the body (10) having four flat side walls (13) and a front opening, holes (34) being provided for the fixing screws (41) at the corners of the lid (20),
**characterized in that**
- the lid (20) comprises a thin plate (22) with folded edges (23), the plate being provided at the corners with cut-out openings (24) larger than the recesses for the fixing screw heads,
- the lid (20) comprises corner pieces (30) added on top of the plate (22) to cover the openings, by being applied by a strip (31) to the top surface (22a) of the plate,
- each corner piece (30) includes a hole (34) designed for the insertion of the respective fixing screw (41) along its axis.

2. Box according to Claim 1, **characterized in that** the opening (24) in the thin plate (22) is delimited by corner lengths (23a) of the folded edges (23).

3. Box according to Claim 1, **characterized in that** the corner piece (30) has a side wall (32) covering the corner lengths (23a) of the folded edges (23) of the lid (20).

4. Box according to Claim 3, **characterized in that** the side wall (32) offers, towards the inside, assembly shapes (32b) cooperating with complementary shapes (23b) provided on the corner lengths (23a) of the folded edges (23).

5. Box according to Claim 3, **characterized in that** the side wall (32) forms a V (31).

6. Box according to Claim 1, **characterized in that** the corner piece (30) has a hole (34) suited to the type of fixing screw (41).

7. Box according to Claim 6, **characterized in that** the corner piece (30) has a side wall (32) covering the corner lengths (23a) of the folded edges (23) of the lid (20) and that the hole (34) suited to the type of fixing screw is provided in a block (33) such that the corner lengths (23a) of the folded edges (23) of the lid are inserted or rebated between the block (33) and the side wall (32).

8. Box according to one of Claims 1 to 7, **characterized in that**,
- the front opening of its body (10) is delimited by a continuous frame formed by returns (13e) of its side walls (13), each return being extended by a raised straight line edge (15) substantially parallel to the wall,
- the ends of the raised edges (15) located at the corners of the body (10) are interconnected by transition edges (17), oriented so as to provide substantially triangular corner lands (16) at the corners of the body,
- on the side of the corner land (16) facing the lid, there is a receiving element (42, 43, 44), disposed in a sealed manner with respect to the internal space of the body, and cooperating, also in a sealed manner with respect to the internal space and practically without reducing the useful volume of this space under the corner land, with the lid fixing screw (41).

9. Box according to Claim 8, **characterized in that** in at least one corner of the body, the angled transition edge (17) and the associated corner land (16) are formed by stamping with the rest of the body.

10. Box according to Claim 8, **characterized in that**, in at least one corner of the body, the angled transition edge (17) and the associated corner land (16) are formed by folding from a side wall (13b) of the body and are welded to the adjacent wall (13a) and to the return and to the raised edge (15) of the adjacent wall (13a).

11. Box according to Claim 8, **characterized in that**, in at least one corner of the body, the angled transition edge (17) and the associated corner land (16) are provided on a corner piece (18), of generally triangular shape, added and fixed in a sealed manner to the returns (13e) and raised edges (15) of the walls (13a, 13b) forming the respective corner.

12. Box according to Claim 11, **characterized in that** the corner piece (18) has flanges inserted under the returns (13e) of the side walls (13).

13. Box according to Claim 8, **characterized in that** the corner land (16) has a lead-through (16a) that communicates with the interior of the body, and the screw-receiving element is a blind insert (42) having a flange (42b) fixed to the corner land and a blind tube (42c) penetrating into the internal space of the body over a short distance below the land, the insert being provided with internal shapes (42a) for tightening the fixing screw (41) by threading or by quarter-turn effect.

14. Box according to Claim 8, **characterized in that** the corner land (16) has no lead-through, the receiving element being a blind hole (44) stamped into the corner land (16) and internally threaded (44a) for tightening the fixing screw (41).

15. Box according to Claim 8, **characterized in that** the corner land (16) has no lead-through, and the receiving element is a part (43) serving as a nut, this nut part having a flat form, notably in the form of an inverted U, provided with a core (43a) with a tapped hole designed to cooperate with the fixing screw (41) and tabs (43d) for fixing to the outer surface of the corner land (16).

16. Box according to Claim 8, **characterized in that** the lid fixing screw (41) is a quarter-turn type and the receiving element (42, 43) is designed to lock this screw in the closed position.

17. Box according to Claim 8, **characterized in that** each return being extended by a raised straight line edge (15) substantially parallel to the wall forms a continuous contour for applying a sealing strip (21) for sealing the lid (20).

## Patentansprüche

1. Metallisches Gehäuse, insbesondere für elektrische Organe, das einen im Wesentlichen parallelepipedischen Körper (10) aufweist, der von einem Deckel, einer Tür oder einem analogen metallischen Organ (20) mit Hilfe von Befestigungsschrauben (41) verschließbar ist, die an den Ecken angeordnet sind, wobei der Körper (10) vier ebene Seitenwände (13) und eine stirnseitige Öffnung aufweist, wobei Aufnahmen (34) für die Befestigungsschrauben (41) an den Ecken des Deckels (20) vorgesehen sind,
**dadurch gekennzeichnet, dass**
- der Deckel (20) eine dünne Platte (22) mit Umbördelungen (23) aufweist, wobei die Platte an den Ecken mit ausgeschnittenen Durchgangsöffnungen (24) versehen ist, die größer sind als die Aufnahmen der Köpfe der Befestigungsschrauben,
- der Deckel (20) Eckbeschläge (30) aufweist, die über der Platte (22) aufgesetzt sind, um die Durchgangsöffnungen zu bedecken, indem sie von einer Leiste (31) auf die Oberseite (22a) der Platte aufgelegt werden,
- jeder Eckbeschlag (30) eine Aufnahme (34) aufweist, die für eine Einführung der jeweiligen Befestigungsschraube (41) gemäß ihrer Achse geeignet ist.

2. Gehäuse nach Anspruch 1, **dadurch gekennzeichnet, dass** die Durchgangsöffnung (24) der dünnen Platte (22) von Winkelzonen (23a) der Umbördelungen (23) begrenzt wird.

3. Gehäuse nach Anspruch 1, **dadurch gekennzeichnet, dass** der Eckbeschlag (30) eine Seitenwand (32) aufweist, die die Winkelzonen (23a) der Umbördelungen (23) des Deckels (20) bedeckt.

4. Gehäuse nach Anspruch 3, **dadurch gekennzeichnet, dass** die Seitenwand (32) nach innen Montageformen (32b) aufweist, die mit komplementären Formen (23b) zusammenwirken, die in den Winkelzonen (23a) der Umbördelungen (23) vorgesehen sind.

5. Gehäuse nach Anspruch 3, **dadurch gekennzeichnet, dass** die Seitenwand (32) ein Dieder (31) bildet.

6. Gehäuse nach Anspruch 1, **dadurch gekennzeichnet, dass** der Eckbeschlag (30) eine Aufnahme (34) aufweist, die an den Typ der Befestigungsschraube (41) angepasst ist.

7. Gehäuse nach Anspruch 6, **dadurch gekennzeichnet, dass** der Eckbeschlag (30) eine Seitenwand (32) aufweist, die die Winkelzonen (23a) der Umbördelungen (23) des Deckels (20) bedeckt, und dass die an den Typ der Befestigungsschraube angepasste Aufnahme (34) in einem Block (33) derart ausgebildet ist, dass die Winkelzonen (23a) der Umbördelungen (23) des Deckels zwischen den Block (33) und die Seitenwand (32) eingefügt oder eingepasst werden.

8. Gehäuse nach einem der Ansprüche 1 bis 7, **dadurch gekennzeichnet, dass**,
- die stirnseitige Öffnung seines Körpers (10) von einem durchgehenden Rahmen begrenzt wird, der von Rücksprüngen (13e) seiner Seitenwände (13) gebildet wird, wobei jeder Rücksprung sich durch einen geradlinigen Rand (15) verlängert, der im Wesentlichen parallel zur Wand hochsteht,
- die Enden der hochstehenden Ränder (15), die sich an den Ecken des Körpers (10) befinden, miteinander durch Übergangsränder (17) verbunden sind, die so ausgerichtet sind, dass an den Ecken des Körpers im Wesentlichen dreieckige Winkelbereiche (16) ausgebildet werden,
- auf der Seite des Winkelbereichs (16), die sich zum Deckel hin befindet, ein Aufnahmeelement (42, 43, 44) vorgesehen ist, das dicht gegenüber dem Innenraum des Körpers angeordnet ist und ebenfalls dicht gegenüber dem Innenbereich und praktisch ohne das Nutzvolumen dieses Raums unter dem Winkelbereich zu verringern mit der Befestigungsschraube (41) des Deckels zusammenwirkt.

9. Gehäuse nach Anspruch 8, **dadurch gekennzeichnet, dass** in mindestens einer Ecke des Körpers der schräge Übergangsrand (17) und der zugeordnete Winkelbereich (16) durch Tiefziehen mit dem Rest des Körpers hergestellt werden.

10. Gehäuse nach Anspruch 8, **dadurch gekennzeichnet, dass** in mindestens einer Ecke des Körpers der schräge Übergangsrand (17) und der zugeordnete Winkelbereich (16) durch Falten ausgehend von einer Seitenwand (13b) des Körpers hergestellt und an die benachbarte Wand (13a) und an den Rücksprung und an den aufgerichteten Rand (15) der benachbarten Wand (13a) geschweißt werden.

11. Gehäuse nach Anspruch 8, **dadurch gekennzeichnet, dass** in mindestens einer Ecke des Körpers der schräge Übergangsrand (17) und der zugeordnete Winkelbereich (16) auf einem Winkelprofilteil (18) von allgemein dreieckiger Form vorgesehen sind, das aufgesetzt und dicht an den Rücksprüngen (13e) und hochstehenden Rändern (15) der Wände (13a, 13b) befestigt ist, die die jeweilige Ecke bilden.

12. Gehäuse nach Anspruch 11, **dadurch gekennzeichnet, dass** das Winkelprofilteil (18) Flügel hat, die unter die Rücksprünge (13e) der Seitenwände (13) eingefügt sind.

13. Gehäuse nach Anspruch 8, **dadurch gekennzeichnet, dass** der Winkelbereich (16) einen Durchgang (16a) aufweist, der mit dem Inneren des Körpers in Verbindung steht, und das Schraubenaufnahmeelement ein Blindeinsatz (42) ist, der einen Kragen (42b), der am Winkelbereich befestigt ist, und ein Blindrohr (42c) aufweist, das in den Innenraum des Körpers über eine geringe Höhe unterhalb des Bereichs eindringt, wobei der Einsatz mit Innenformen (42a) für das Anziehen der Befestigungsschraube (41) durch Gewinde oder Vierteldrehungswirkung versehen ist.

14. Gehäuse nach Anspruch 8, **dadurch gekennzeichnet, dass** der Winkelbereich (16) keinen Durchgang aufweist, wobei das Aufnahmeelement ein Sackloch (44) ist, das in dem Winkelbereich (16) tiefgezogen und mit einem Innengewinde (44a) zum Anziehen der Befestigungsschraube (41) versehen ist.

15. Gehäuse nach Anspruch 8, **dadurch gekennzeichnet, dass** der Winkelbereich (16) keinen Durchgang aufweist, und das Aufnahmeelement ein Bauteil (43) mit der Funktion einer Mutter ist, wobei dieses Mutter-Bauteil eine flache Form insbesondere eines umgekehrten U aufweist, die mit einem Steg (43a) mit Gewindeloch, das vorgesehen ist, um mit der Befestigungsschraube (41) zusammenzuwirken, und mit Laschen (43d) zur Befestigung an der Außenseite des Winkelbereichs (16) versehen ist.

16. Gehäuse nach Anspruch 8, **dadurch gekennzeichnet, dass** die Befestigungsschraube (41) des Deckels vom Vierteldrehungstyp ist und das Aufnahmeelement (42, 43) geeignet ist, um diese Schraube in der Schließstellung zu blockieren.

17. Gehäuse nach Anspruch 8, **dadurch gekennzeichnet, dass** jeder Rücksprung, der sich durch einen geradlinigen Rand (15) verlängert, der im Wesentlichen parallel zur Wand hochsteht, einen durchgehenden Umriss für das Auflegen einer Dichtung (26) bildet, die die Dichtheit des Deckels (20) gewährleistet.
